(19) **Europäisches Patentamt**
**European Patent Office**
**Office européen des brevets**

(11) **EP 4 752 629 A1**

(12) **EUROPEAN PATENT APPLICATION**

(43) Date of publication:
**03.06.2026 Bulletin 2026/23**

(51) International Patent Classification (IPC):
*G03F 7/00* (2006.01)

(21) Application number: **24216218.8**

(22) Date of filing: **28.11.2024**

(52) Cooperative Patent Classification (CPC):
**G03F 7/706845; G03F 7/70575; G03F 7/706847**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
• **REIJNDERS, Marinus Petrus**
**5500 AH Veldhoven (NL)**
• **COENEN, Teis Johan**
**5500 AH Veldhoven (NL)**
• **VAN DER ZOUW, Gerbrand**
**5500 AH Veldhoven (NL)**

(74) Representative: **ASML Netherlands B.V.**
**Corporate Intellectual Property**
**P.O. Box 324**
**5500 AH Veldhoven (NL)**

(54) **CALIBRATING AN APPARATUS**

(57) An apparatus comprising: a diffractive optical element; a primary radiation source configured to illuminate the diffractive optical element with primary radiation; and a reference radiation source configured to illuminate the diffractive optical element with reference radiation; wherein the diffractive optical element has a first periodicity configured to diffract the primary radiation, and a second periodicity configured to diffract the reference radiation. The apparatus further comprises: a detector arranged to detect the primary radiation diffracted by the diffractive optical element and the reference radiation diffracted by the diffractive optical element; and a processor configured to determine a wavelength related parameter of the detected primary radiation based on a wavelength related parameter of the detected radiation. A method for calibrating an apparatus, such as a metrology apparatus, is also described.

**Fig. 12**

## Description

FIELD

The present invention relates to calibrating an apparatus.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA. where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low $k_1$.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating/target medium, thereby generating an emitted radiation, optionally a high harmonic generation (HHG) comprising high frequency radiation.

In order to obtain useful information about the metrology target, it is important that precise information about the radiation used for the metrology is known, including its spectral characteristics.

SUMMARY

The present disclosure provides a way to obtain a wavelength calibration of radiation using a diffractive optical measurement having at least two periodicities. A first periodicity is configured to diffract primary radiation (i.e. the measurement radiation), and the second periodicity is configured to diffract reference radiation, which has a known wavelength (e.g., the reference radiation may be laser radiation having a known wavelength). The wavelength calibration can be obtained based on the reference radiation, using a ratio of the first and second periodicities, rather than requiring precise measurement of the pitch of the diffraction grating, or the distance between the diffraction grating and the detector.

Described herein is an apparatus, optionally an optical apparatus, optically a metrology apparatus comprising: a diffractive optical element; a primary radiation source configured to illuminate the diffractive optical element with primary radiation; and a reference radiation source configured to illuminate the diffractive optical element with reference radiation; wherein the diffractive optical element has a first periodicity configured to diffract the primary radiation, and a second periodicity configured to diffract the reference radiation. The apparatus further comprises: a detector arranged to detect the primary radiation diffracted by the diffractive optical element and the reference radiation diffracted by the diffractive optical element; and a processor configured to determine a wavelength related parameter of the detected primary radiation based on a wavelength related parameter of the detected radiation.

Also described herein is a method for calibrating an apparatus (such as a metrology apparatus), the method comprising; illuminating a diffractive optical element with a primary radiation and a reference radiation, the diffractive optical element having a first periodicity configured to diffract the primary radiation, and a second periodicity configured to diffract the reference radiation; and determining a wavelength related parameter of the diffracted primary radiation based on a wavelength related parameter of the diffracted reference radiation.

It will be understood that a wavelength related parameter according to the present disclosure may be a wavelength, or another parameter from which a wavelength may be derived.

BRIEF DESCRIPTION OF THE DRAWINGS

Embodiments will now be described, by way of example only, with reference to the accompanying schematic drawings, in which:

- Figure 1 depicts a schematic overview of a lithographic system comprising a lithographic apparatus and a radiation source;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 depicts a simplified schematic drawing of diffraction of a primary radiation beam by a single period diffraction grating, according to a known method for calibrating an apparatus;
- Figures 9(a) and (b) depict simplified schematic drawings of diffraction of reference radiation and primary radiation, respectively, by a diffraction grating having a first periodicity and a second periodicity according to the present disclosure;
- Figure 10(a) illustrates an example of a single period, or single pitch, diffraction grating;

- Figures 10(b)-(d) illustrate examples of a diffraction gratings having first and second periodicities according to the present disclosure;
- Figure 11(a) illustrates an example of a regular square 2D diffraction grating;
- Figures 11(b) and (c) illustrate examples of 2D diffraction gratings according to the present disclosure;
- Figure 12 illustrates an example of an apparatus according to the present disclosure, in which the primary radiation and the reference radiation are arranged to illuminate the diffractive optical element collinearly; and
- Figure 13 is a flow diagram of an example of a method for calibrating an apparatus, such as a metrology apparatus, according to the present disclosure.

DETAILED DESCRIPTION

Before describing embodiments of the invention in detail, it is instructive to present an example environment in which embodiments of the present invention may be implemented.

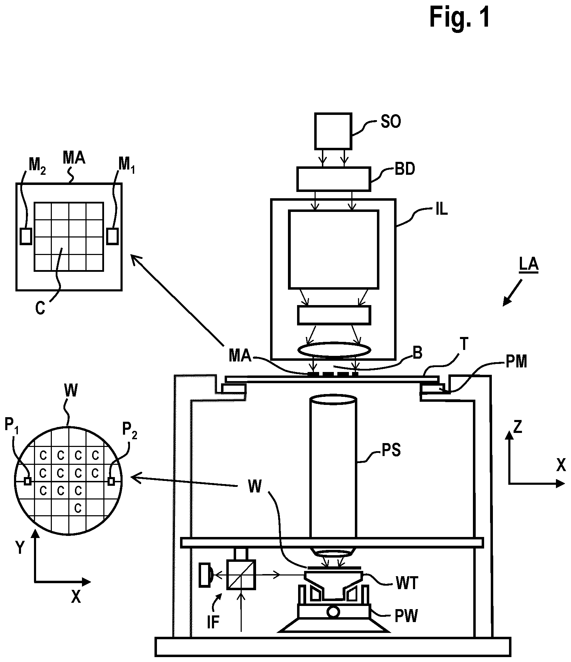

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that may be smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source, high harmonic generation (HHG) source or a free electron laser (FEL) may be used to generate EUV radiation.

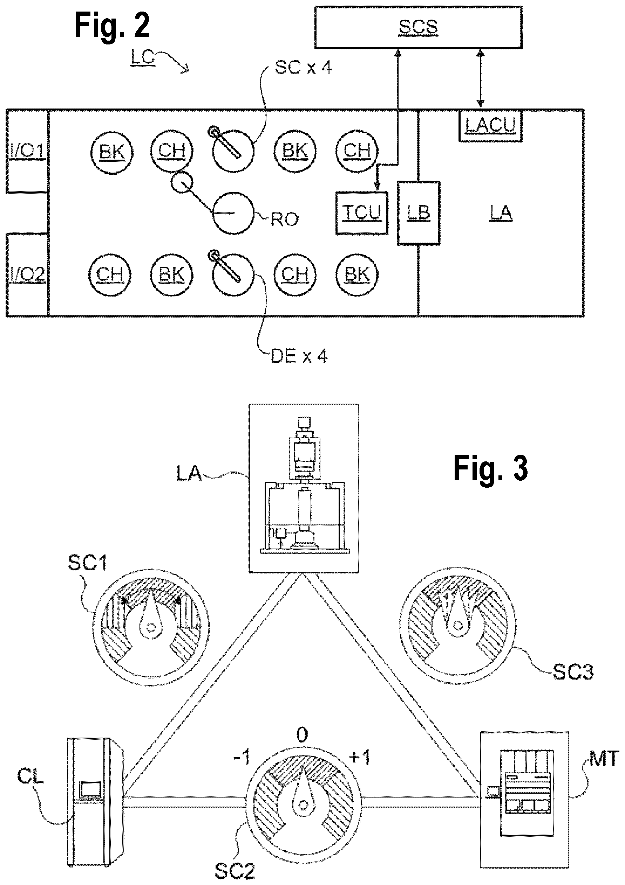

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

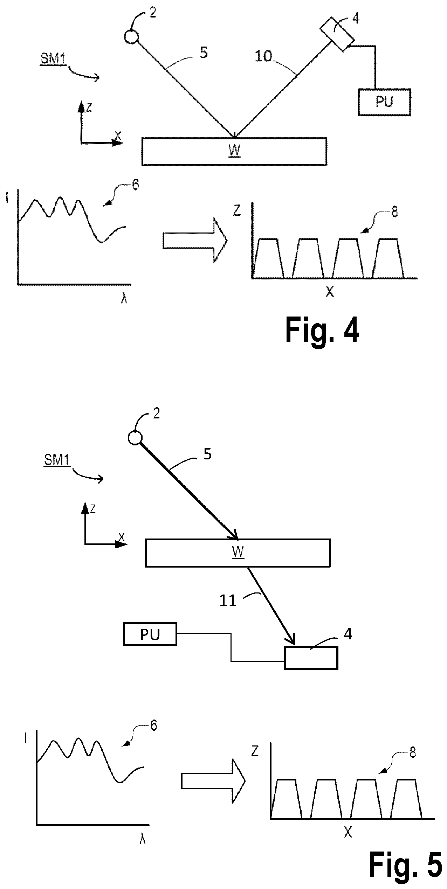

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

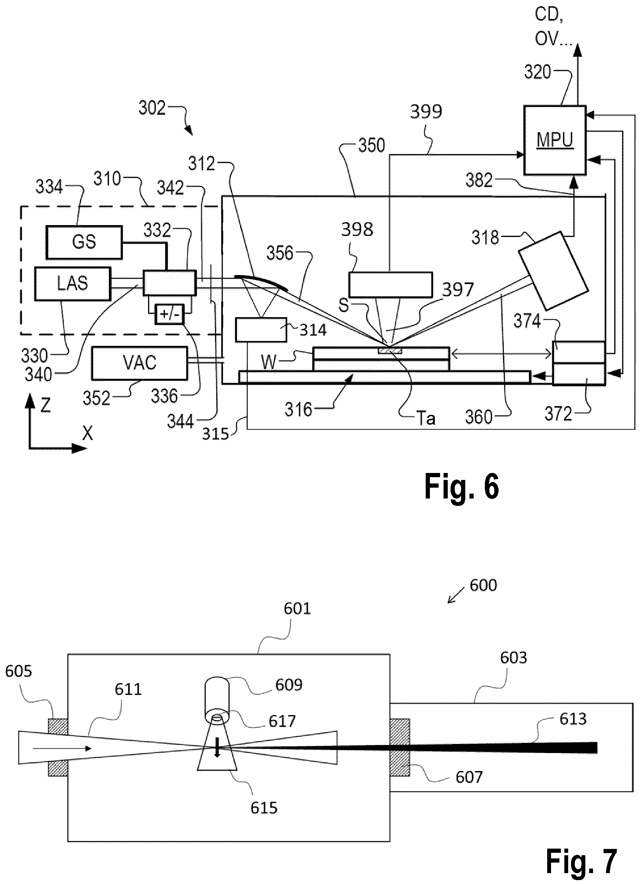

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source, as well as other types of sources, may have a gas target and be a gas jet/nozzle source, a capillary/fiber source or a gas cell source. The HHG source, as well as other types of sources, may have a solid or liquid target. Although HHG source with gas target is described in the text below, it will be appreciated that the invention is not limited to HHG source with gas target and may be used in HHG source with solid or liquid target and other types of source with any target. The gas target, solid target and liquid target may be referred as generating/target medium.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to $10\mu m$, for example in the region of $1\mu m$ (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen ($N_2$), Oxygen ($O_2$), Argon (Ar), Krypton (Kr), Xenon (Xe), Carbon dioxide and the combination of them. These may be selectable options within the same apparatus. The emitted radiation may contain multiple wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 $\mu$m in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use HHG or any other types of sources mentioned above to obtain radiation at the desired wavelength(s).

Figure 7 shows a simplified schematic drawing of an embodiment 600 of an illumination source 310, which may be the illumination source for HHG. One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen ($N_2$), Oxygen ($O_2$), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermal deformation due to the high-power pump radiation 611.

The dimensions of the gas nozzle 609 may conceivably also be used in scaled-up or scaleddown versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. fewcycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV SXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUV SXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Although specific reference is made to HHG, it will be appreciated that the invention, where the context allows, may be practiced with all radiation sources. In one embodiment, the radiation source is a laser produced plasma (LPP) source as mentioned above, for hard X-ray, soft X-ray, EUV, DUV as well as visible illumination generation. In one embodiment, the radiation source is one of liquid metal jet source, inverse Compton scattering (ICS) source, plasma channel source, magnetic undulator source, free electron laser (FEL) source, compact storage ring source, electrical discharge produced plasma source, rotating anode source, solid anode source, particle accelerator source, and microfocus source.

As described above, the geometry of a target substrate may can be reconstructed from a diffraction pattern that is reflected or scattered by the substrate, where the diffraction pattern contains information about the geometry of the target substrate. In order to perform the reconstruction, the properties of the radiation used to perform the measurement (also described herein as "primary radiation" or "measurement information") must be precisely known. These properties include the wavelength, or wavelength spectrum, of the radiation, and a calibration is therefore required.

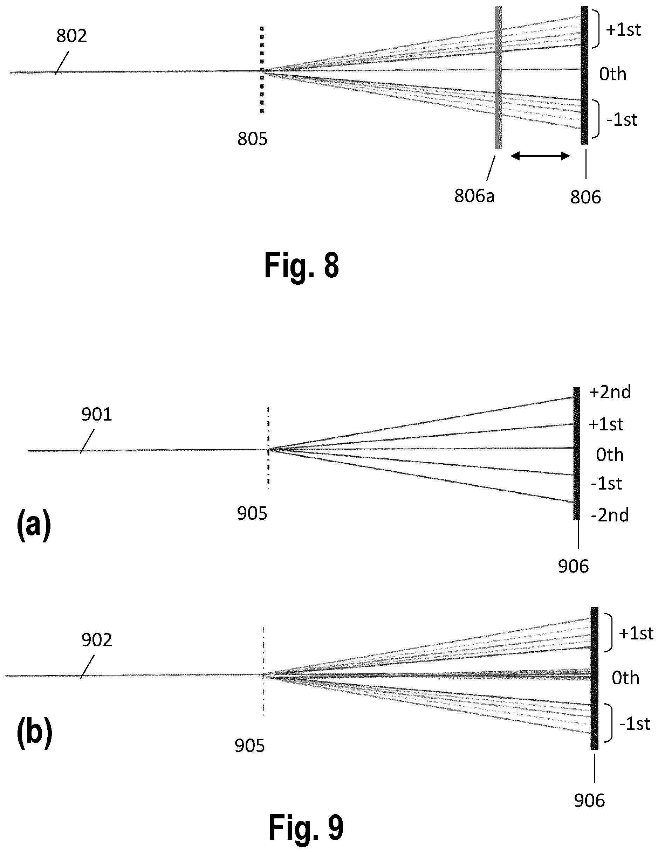

Figure 8 illustrates an example of diffraction of a primary (i.e. measurement) radiation beam 802 by a single period diffraction grating 805, according to a known method for calibrating an apparatus, optionally an optical apparatus, optically a metrology apparatus. The term "metrology apparatus" is used here solely for illustrative purposes. The metrology apparatus may be a metrology tool (e.g. a scatterometer) as described herein. The diffracted primary radiation is incident on a detector 806, such as a camera (Figure 8 shows the $0^{th}$ diffraction order, and the $+1^{st}$ and $-1^{st}$ diffraction orders). To be able to determine the absolute wavelength calibration of the primary radiation 802, it is required to know the grating pitch (i.e. the distance between grating slits), the distance between the grating 805 and the detector 806 (and any tilt of the detector 806), and the size of pixels of the detector 806 to a high degree of precision (e.g. within ~ 10 ppm according to some specifications). Currently, the grating pitch is calibrated externally at a beamline facility, while the distance between the grating 805 and the detector 806 is determined by performing multiple measurements with the detector 806 at different positions relative to the grating 805 (illustrated in Figure 8 by the position 806a), and fitting the distance based on the expansion of the diffracted beam. It is therefore highly challenging, and costly, to obtain these values precisely, and to keep them stable over time.

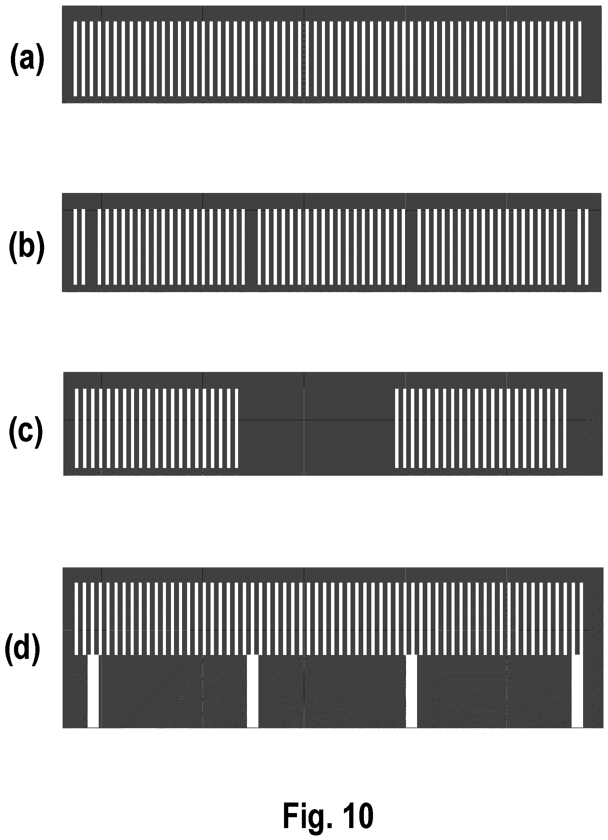

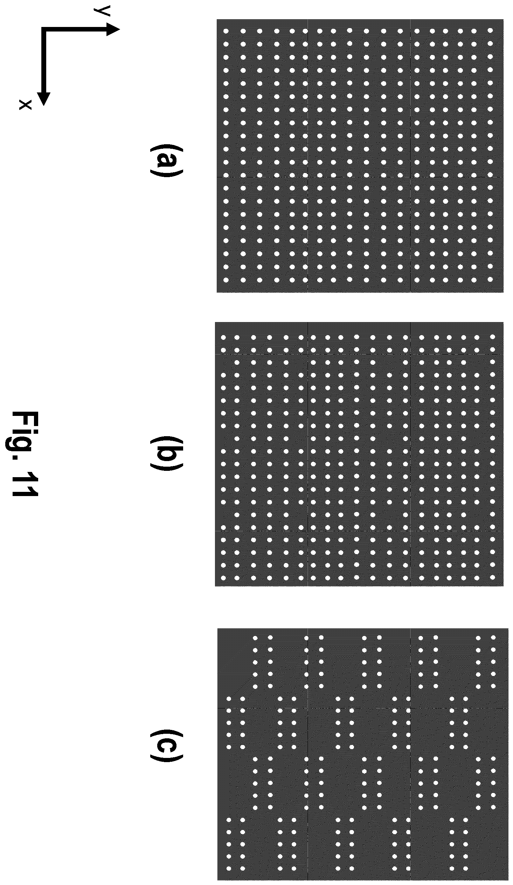

Figures 9(a) and (b) illustrate an example of an alternative calibration technique according to the present disclosure. In the example illustrated in Figures 9(a) and (b), and described herein, instead of a single period diffraction grating, a diffractive optical element 905 having at least two periodicities is placed in the radiation path. The diffractive optical element 905, described in more detail below with reference to Figures 10 and 11, has a first periodicity, or grating pitch, configured to diffract the primary radiation 902, and a second periodicity, or grating pitch, configured to diffract reference radiation 901. As shown in Figure 9(a), reference radiation 901 having a precisely known wavelength (e.g. provided by a reference radiation source such as a laser) illuminates the diffractive optical element 905, and the diffracted reference radiation is incident on the detector 906 (the $0^{th}$, $+1^{st}$, $+2^{nd}$, $-1^{st}$, and $-2^{nd}$ diffraction orders are shown in Figure 9(a)). As an example, the reference radiation source may comprise a Helium-Neon (HeNe) laser, and the reference radiation 901 may have a known wavelength such as 632.8 nm. In another step (e.g. subsequently), as shown in Figure 9(b), the primary radiation 902 illuminates the diffractive optical element 905, and the diffracted primary radiation is incident on the detector 906 (the $0^{th}$, $+1^{st}$, and $-1^{st}$ diffraction orders are shown in Figure 9(b)).

Figure 10(a) illustrates an example of a single period, or single pitch, diffraction grating (e.g. corresponding to the diffraction grating 805 of the known calibration technique illustrated in Figure 8). In contrast, Figures 10(b)-(d) illustrate some examples of diffractive optical elements having two periods or pitches (i.e. suitable for use as the diffractive optical element 905 illustrated in Figures 9(a) and 9(b)) according to the present disclosure. The diffractive optical elements described herein may be referred to as "multi pitch gratings" or "supergratings". Figure 10(b) illustrates an example of a diffractive optical element in which multiple periods, or pitches, are formed by removing a grating line at regular intervals. Figure 10(c) illustrates an example of a diffractive optical element in which multiple periods, or pitches, are formed by binary multiplying. Figure 10(d) illustrates an example of diffractive optical element in which multiple periods, or pitches, are formed by having two gratings of different pitches close together, or adjacent.

In the examples illustrated herein, the primary radiation is broadband radiation (which may comprise, e.g. SXR radiation). The spectrum of the primary radiation may, in some examples, comprise a plurality of sharp spectral peaks. It will be appreciated that the methods and apparatuses described herein may also be applied to calibration of single wavelength primary radiation (e.g. laser radiation). The reference radiation may have a longer wavelength than the primary radiation. Or, in the case of broadband primary radiation, the reference radiation may have a wavelength that is longer than any wavelength in the primary radiation spectrum.

According to the present disclosure, the wavelength(s) (or a wavelength related parameter) of the primary radiation 902 incident on the detector 906 can be calibrated according to the known wavelength of the reference radiation, because the ratio of the first periodicity and the second periodicity of the diffractive optical element is known, where the wavelength of the primary radiation, $\lambda_{primary}$, is related to the wavelength of the reference radiation, $\lambda_{reference}$, and the pitch of the first periodicity (i.e. the pitch of the diffractive optical element configured to diffract the primary radiation), $a_{primary}$, the pitch of the second periodicity (i.e. the pitch of the diffractive optical element configured to diffract the reference radiation, ($a_{reference}$), for a given primary radiation diffraction order, $i_{primary}$, and reference radiation diffraction order, $i_{reference}$, by

$$\lambda_{primary} = \lambda_{reference} * \left(\frac{a_{primary}}{i_{primary}} \middle/ \frac{a_{reference}}{i_{reference}}\right). \ (1)$$

Advantageously, therefore, only the reference radiation wavelength and the pitch ratio between the first and second periodicities need to be known to a high degree of accuracy, removing the need for costly and difficult measurements of the absolute grating pitch, or the distance between the diffractive optical element and the detector.

Preferably, the second periodicity is an integer multiple of the first periodicity (or the first periodicity is an integer multiple of the second periodicity), so that the ratio can be known precisely. The ratio between the two grating pitches should also preferably be the same or similar to the ratio of the primary and reference radiation wavelengths, within an order of magnitude. In some examples, an additional factor, *b,* may be applied to cause more diffraction orders of the reference radiation to be incident on the detector (i.e. to generate more spots of the detector), to increase the precision of the calibration. As an example, $\lambda_{primary}$ = 15 nm, $\lambda_{reference}$ = 630 nm, and *b* = 3. Therefore, as an example, according to Equation (1), and rounding the ratio of the primary and reference wavelengths, a first pitch of the lines (i.e. defining the first periodicity) of the diffractive optical element may be 200 nm for SXR primary radiation, and a second pitch (defining the second periodicity) may be 2800 nm for HeNe laser light as the reference radiation:

$$a_{reference} = a_{primary} * \mathrm{round}\left(\frac{\lambda_{reference}}{\lambda_{primary}}\right) / b) = 200 \ \mathrm{nm} * \mathrm{round}(15 \ \mathrm{nm}/630 \ \mathrm{nm} \ / \ 3) = 2800 \ \mathrm{nm}. \ (2)$$

As a single piece, the diffraction grating should advantageously retain the same ratio between the periodicities, even following expansion due to heating (e.g. caused by the incident radiation) reducing the need for multiple calibrations.

As an example, the diffractive optical element may comprise a thin membrane with slits forming the grating. While the examples described and illustrated in the present disclosure primarily relate to transmissive gratings, the diffractive optical element could alternatively, or additionally, be a reflective optical element, to either or both of the primary radiation and the secondary radiation.

The example diffractive optical elements illustrated in Figure 10 are one-dimensional (1D) diffraction gratings, with the first periodicity and the second periodicity being in a same direction (e.g. the x-direction). In some examples, the diffractive optical element may comprise a two-dimensional (2D) diffraction grating. Figure 11(a) illustrates an example of a regular square 2D diffraction grating, which may comprise blocks or holes arranged in a checkerboard formation. Figure 11(b) illustrates an example of a square 2D grating having a first periodicity and a second periodicity, and additionally a third periodicity and a fourth periodicity, arranged in a 2D formation in the x and y directions. The third and fourth periodicities match the first and second periodicities to diffract the primary radiation and the reference radiation, respectively. In the example illustrated in Figure 1 1(c), the 2D grating has a first periodicity in both x and y, configured to diffract the primary radiation, and a second periodicity in both x and y, configured to diffract the reference radiation. In some examples of a 2D grating, the periodicity configured to diffract the primary radiation may be in a first direction, while all of the other periodicities may be configured to diffract the reference radiation, or vice versa. In some examples (not shown), a 2D diffraction grating may comprise non-rectangular unit cells. In some examples (not shown), a 2D diffraction grating may have different angles between the pitches of the periodicities configured to diffract the primary radiation and the reference radiation, respectively. Preferably, the parameters of a 2D diffraction grating are chosen such that there is a periodic match between the grating features configured to diffract the primary radiation, and the grating features configured to diffract the reference radiation.

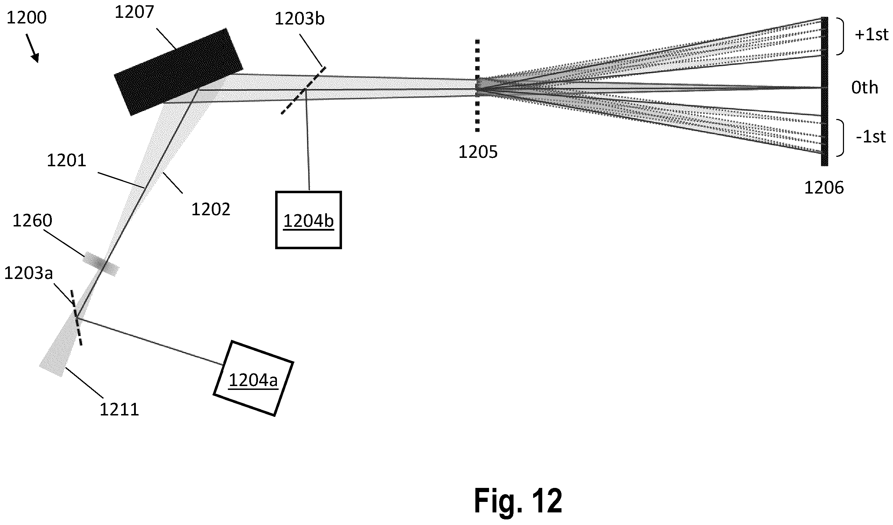

Figure 12 illustrates an example of an apparatus, optionally an optical apparatus, optically a metrology apparatus 1200 according to the present disclosure. In the example illustrated in Figure 12, primary radiation 1202 and reference radiation 1201 are both incident collinearly on a diffractive optical element 1205. The diffractive optical element 1205 may comprise any suitable diffractive optical element having at least a first periodicity and a second periodicity, as described herein (e.g. any of the diffractive optical elements illustrated in Figures 9(b)-(d), 10(b), and 10(c)). As shown in Figure 12, the primary radiation 1202 may be produced by pump radiation (e.g. pulsed pump radiation) interacting with an illumination source 1260, such as an illumination source for HHG as described above and illustrated in Figure 7. For example, the illumination source 1260 in Figure 12 may correspond to the illumination source 600 illustrated in Figure 7. The illumination source 1260 and, optionally, the source of the pump radiation 1211 (not shown) may be referred to collectively as a primary radiation source. The primary radiation 1202 may comprise SXR radiation. In some examples, the primary radiation comprises radiation having a wavelength in the range 0.1-100 nm, for example 1-50 nm, 5-20 nm, 5-10 nm, or 10-20 nm. A toroidal focusing mirror 1207, or other suitable optical element(s), may be used to steer the primary radiation 1202 towards the diffractive optical element 1205. The reference radiation 1201 may be provided by a reference radiation source 1204a, 1204b, such as a HeNe laser. For example, the reference radiation 1201 may comprise radiation having a well-known wavelength of around 630 nm, e.g. 632.8 nm. It will be appreciated that, in Figure 12, only the chief ray of the reference radiation 1201 is shown for clarity (i.e. the rest of the beam including divergence has been omitted).

In a first example, shown in Figure 12, the reference radiation source 1204a may be arranged such that the reference radiation 1201 is also incident on the toroidal mirror 1207 (i.e. such that the reference radiation source 1204a is positioned before the toroidal mirror 1207 with respect to the optical path). A mirror 1203a or other optical element may be used to direct the reference radiation 1201 towards the toroidal mirror 1207. As described herein, the generation of the primary radiation (e.g. by HHG) may require vacuum, or near-vacuum conditions to take place. Other elements of the metrology apparatus 1200 may also be under vacuum, or near vacuum, conditions as described herein. Therefore, providing the reference radiation before the toroidal mirror 1207, and before the illumination source 1260 as shown in Figure 12, may therefore be more straightforward than aligning the reference radiation 1201 within the vacuum system. In addition, the reference radiation 1201 and the primary radiation 1202 can both be focused onto the diffractive optical element 1205 by the same optics, simplifying the alignment process to achieve collinearity of the beams.

In some examples, the reference radiation 1201 may be the pump radiation 1211 (e.g. without the HHG process active).

Alternatively, in a second example illustrated in Figure 12, the reference radiation source 1204b may be arranged such that the reference radiation 1201 is provided to the optical path after the toroidal mirror 1207 (e.g. using a mirror 1203b or other suitable optical element). This arrangement may enable a higher degree of control of the reference radiation 1201, and may provide a higher NA beam to achieve a smaller spot on the detector 1206. However, it will be appreciated that the NA of the optics used to direct and focus the primary radiation 1202 (e.g. SXR radiation) is in general quite small (e.g. ~ 2 mrad), which for a HeNe reference radiation beam results in a diffraction spot of ~ 160 $\mu$m. This is still sufficiently small to enable precise determination of the center position of the spot.

While the primary radiation 1202 and the reference radiation 1201 are shown in Figure 12 as being incident on the diffractive optical element 1205, and the detector 1206, at the same time, it will be understood that in general the diffractive optical element 1205 may be illuminated by the reference radiation 1201 separately from the primary radiation 1202, as part of a calibration process.

Arranging the primary radiation 1202 and the reference radiation 1201 such that they illuminate the diffractive optical element 1205 collinearly, as in Figure 12, may advantageously ensure that both beams illuminate the diffractive optical element 1205 in the same way so that the calibration can be performed accurately. The collinearity of the beams can be measured by measuring the location of both the primary radiation and reference radiation near the point at which the beams mix, and at far field. However, it will be understood that, in an alternative example, the primary radiation 1202 and the reference radiation 1201 may not be collinear. In this example, a known angle between the beams can be used to determine the calibration.

In some examples, the diffractive optical element described herein may be configured as a reflective diffractive optical element. For example, the diffractive optical element may comprise a reflective supergrating on the toroidal mirror 1207 illustrated in Figure 12. This may enable continuous monitoring of the calibration by providing a reference branch of the reflected beam that can be directly calibrated.

In apparatuses described herein (including the apparatus 1200 illustrated in Figure 12), the determination of the wavelength (or wavelength related parameter) of the primary radiation based on the reference radiation may be performed by a processor (not shown) configured to execute machine-readable instructions that enable determination of the wavelength parameter of the detected primary radiation based on a wavelength related parameter of the detected reference radiation. For example, the processor may be connected to the detector. As described herein, the processor may also be configured to control other aspects of the apparatus, and other apparatuses described herein.

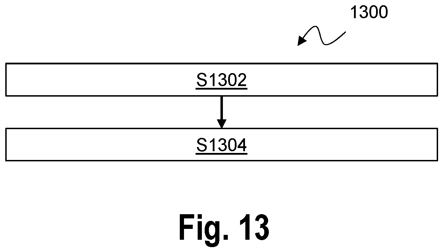

Figure 13 is a flow diagram illustrating a method 1300 for calibrating an apparatus, optionally an optical apparatus, optically a metrology apparatus, according to the present disclosure. For example, the method 1300 may be suitable for calibrating a metrology apparatus described herein, such as the metrology apparatus 1200 illustrated in Figure 12.

In a step S1302, the method 1300 comprises illuminating a diffractive optical element with a primary radiation and a reference radiation, the diffractive optical element having a first periodicity configured to diffract the primary radiation, and a second periodicity configured to diffract the reference radiation. As described herein, the primary radiation may be broadband radiation. The primary radiation may comprise SXR radiation. In some examples, the primary radiation comprises radiation having a wavelength in the range 0.1-100 nm, for example 1-50 nm, 5-20 nm, 5-10 nm, or 10-20 nm. The primary radiation may be produced by a primary radiation source, e.g. by a HHG process as described herein. The reference radiation may comprise a laser having a single known wavelength. For example, the reference radiation may be provided by a reference radiation source such as a laser (e.g. a HeNe laser). The diffractive optical element may be any suitable 1D or 2D diffractive optical element, such as any of the examples illustrated in Figures 9 and 10 and described herein.

In a step S1304, the method 1300 comprises determining a wavelength related parameter of the diffracted primary radiation based on a wavelength related parameter of the diffracted reference radiation. For example, as described herein, the wavelength related parameter of the diffracted primary radiation can be determined based on a known wavelength of the reference radiation, and a ratio of the pitches of the first and second periodicities of the diffractive optical element (see Equations 1 and 2, described above).

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:

1. An apparatus comprising:

a diffractive optical element;

a primary radiation source configured to illuminate the diffractive optical element with primary radiation; and

a reference radiation source configured to illuminate the diffractive optical element with reference radiation;

wherein the diffractive optical element has a first periodicity configured to diffract the primary radiation, and a second periodicity configured to diffract the reference radiation; and

wherein the apparatus further comprises:

a detector arranged to detect the primary radiation diffracted by the diffractive optical element and the reference radiation diffracted by the diffractive optical element; and

a processor configured to determine a wavelength related parameter of the detected primary radiation based on a wavelength related parameter of the detected reference radiation.

2. An apparatus according to clause 1, wherein the diffractive optical element is configured as a transmissive diffractive optical element.

3. An apparatus according to clause 1, wherein the diffractive optical element is configured as a reflective diffractive optical element.

4. An apparatus according to any one of the preceding clauses, wherein the primary radiation and the reference radiation are arranged to illuminate the diffractive optical element collinearly.

5. An apparatus according to any one of the preceding clauses, wherein a wavelength of the reference radiation is longer than a wavelength of the primary radiation.

6. An apparatus according to any one of the preceding clauses, wherein the primary radiation is broadband radiation.

7. An apparatus according to any one of the preceding clauses, wherein the primary radiation comprises soft X-ray radiation.

8. An apparatus according to any one of the preceding clauses, wherein the primary radiation comprises radiation having a wavelength in the range 0.1-100 nm.

9. An apparatus according to any one of the preceding clauses, wherein the primary radiation comprises radiation having a wavelength in the range 1-50 nm.

10. An apparatus according to any one of the preceding clauses, wherein the primary radiation comprises radiation having a wavelength in the range 5-20 nm.

11. An apparatus according to any one of the preceding clauses, wherein the primary radiation comprises radiation having a wavelength in the range 5-10 nm.

12. An apparatus according to any one of the preceding clauses, wherein the primary radiation comprises radiation having a wavelength in the range 10-20 nm.

13. An apparatus according to any one of the preceding clauses, wherein the second periodicity is an integer multiple of the first periodicity.

14. An apparatus according to any one of clauses 1 to 12, wherein the first periodicity is an integer multiple of the second periodicity.

15. An apparatus according to any one of the preceding clauses, wherein the diffractive optical element comprises a one-dimensional diffraction grating, wherein the first periodicity and the second periodicity are in a same direction.

16. An apparatus according to any one of clauses 1 to 14, wherein the diffractive optical element comprises a two-dimensional diffraction grating.

17. An apparatus according to clause 16, wherein the diffractive optical element has a third periodicity and a fourth periodicity.

18. An apparatus according to clause 17, wherein the first periodicity and the second periodicity are in a first dimension, and the third periodicity and the fourth periodicity are in a second dimension.

19. An apparatus according to clause 17, wherein the first periodicity and the third periodicity are in a first dimension, and wherein the second periodicity and the fourth periodicity are in a second dimension.

20. An apparatus according to any one of clauses 17 to 19, wherein the third periodicity is configured to diffract the primary radiation, and wherein the fourth periodicity is configured to diffract the reference radiation.

21. An apparatus according to clause 17, wherein the third and fourth periodicities are configured to diffract the reference radiation.

22. An apparatus according to clause 21, wherein the first periodicity is in a first dimension and the second, third, and fourth periodicities are in a second dimension.

23. An apparatus according to clause 17, wherein the third and fourth periodicities are configured to diffract the primary radiation.

24. An apparatus according to clause 23, wherein the second periodicity is in a first dimension, and the first, third, and fourth periodicities are in a second dimension.

25. A method for calibrating an apparatus, the method comprising:

illuminating a diffractive optical element with a primary radiation and a reference radiation, the diffractive optical element having a first periodicity configured to diffract the primary radiation, and a second periodicity configured to diffract the reference radiation; and

determining a wavelength related parameter of the diffracted primary radiation based on a wavelength related parameter of the diffracted reference radiation.

26. A method for calibrating an apparatus, the method comprising:

illuminating a diffractive optical element with a primary radiation and a reference radiation, the diffractive optical element having a first periodicity configured to diffract the primary radiation, and a second periodicity configured to diffract the reference radiation; and

determining a wavelength related parameter of the diffracted primary radiation based on a wavelength related parameter of the diffracted reference radiation.

27. A method according to clause 25 or 26, wherein the diffractive optical element is configured as a transmissive diffractive optical element.

28. A method according to clause 25 or 26, wherein the diffractive optical element is configured as a reflective diffractive optical element.

29. A method according to any one of clauses 25 to 28, comprising illuminating the diffractive optical element such that the primary radiation and the reference radiation are collinear.

30. A method according to any one of clauses 25 to 29, wherein a wavelength of the reference radiation is longer than a wavelength of the primary radiation.

31. A method according to any one of clauses 25 to 30, wherein the primary radiation is broadband radiation.

32. A method according to any one of clauses 25 to 31, wherein the primary radiation comprises soft X-ray radiation.

33. A method according to any one of clauses 25 to 32, wherein the primary radiation comprises radiation having a wavelength in the range 0.1-100 nm.

34. A method according to any one of clauses 25 to 33, wherein the primary radiation comprises radiation having a wavelength in the range 1-50 nm.

35. A method according to any one of clauses 25 to 34, wherein the primary radiation comprises radiation having a wavelength in the range 5-20 nm.

36. A method according to any one of clauses 25 to 35, wherein the primary radiation comprises radiation having a wavelength in the range 5-10 nm.

37. A method according to any one of clause 25 to 36, wherein the primary radiation comprises radiation having a wavelength in the range 10-20 nm.

38. A method according to any one of clauses 25 to 37, wherein the second periodicity is an integer multiple of the first periodicity.

39. A method according to any one of clauses 25 to 37, wherein the first periodicity is an integer multiple of the second periodicity.

40. A method according to any one of clauses 25 to 39, wherein the diffractive optical element comprises a one-dimensional diffraction grating, wherein the first periodicity and the second periodicity are in a same direction.

41. A method according to any one of clauses 1 to 39, wherein the diffractive optical element comprises a two-dimensional diffraction grating.

42. A method according to clause 41, wherein the diffractive optical element has a third periodicity and a fourth periodicity.

43. A method according to clause 42, wherein the first periodicity and the second periodicity are in a first dimension, and the third periodicity and the fourth periodicity are in a second dimension.

44. A method according to clause 42, wherein the first periodicity and the third periodicity are in a first dimension, and wherein the second periodicity and the fourth periodicity are in a second dimension.

45. A method according to any one of clauses 42 to 44, wherein the third periodicity is configured to diffract the primary radiation, and wherein the fourth periodicity is configured to diffract the reference radiation.

46. A method according to clause 42, wherein the third and fourth periodicities are configured to diffract the reference radiation.

47. A method according to clause 46, wherein the first periodicity is in a first dimension and the second, third, and fourth periodicities are in a second dimension.

48. A method according to clause 42, wherein the third and fourth periodicities are configured to diffract the primary radiation.

49. A method according to clause 48, wherein the second periodicity is in a first dimension, and the first, third, and fourth periodicities are in a second dimension.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may be made in this text to embodiments of the invention in the context of a metrology apparatus, embodiments of the invention may be used in other apparatus, optionally other optical apparatus, for example an inspection apparatus, and an lithographic apparatus. One further embodiment is an inspection apparatus or an lithographic apparatus comprising: a diffractive optical element; a primary radiation source configured to illuminate the diffractive optical element with primary radiation; and a reference radiation source configured to illuminate the diffractive optical element with reference radiation; wherein the diffractive optical element has a first periodicity configured to diffract the primary radiation, and a second periodicity configured to diffract the reference radiation. The inspection or lithographic apparatus further comprises: a detector arranged to detect the primary radiation diffracted by the diffractive optical element and the reference radiation diffracted by the diffractive optical element; and a processor configured to determine a wavelength related parameter of the detected primary radiation based on a wavelength related parameter of the detected radiation.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

It should be appreciated that the term color is used throughout this text synonymously with wavelength or spectral component and the colors may include those outside the visible band (e.g., infrared or ultraviolet wavelengths).

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 1-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

**Claims**

1. An apparatus comprising:

   a diffractive optical element;
   a primary radiation source configured to illuminate the diffractive optical element with primary radiation; and
   a reference radiation source configured to illuminate the diffractive optical element with reference radiation;
   wherein the diffractive optical element has a first periodicity configured to diffract the primary radiation, and a second periodicity configured to diffract the reference radiation; and
   wherein the apparatus further comprises:

      a detector arranged to detect the primary radiation diffracted by the diffractive optical element and the reference radiation diffracted by the diffractive optical element; and
      a processor configured to determine a wavelength related parameter of the detected primary radiation based on a wavelength related parameter of the detected reference radiation.

2. An apparatus according to claim 1, wherein the diffractive optical element is configured as a transmissive diffractive optical element.

3. An apparatus according to claim 1, wherein the diffractive optical element is configured as a reflective diffractive optical element.

4. An apparatus according to any one of the preceding claims, wherein the primary radiation and the reference radiation are arranged to illuminate the diffractive optical element collinearly.

5. An apparatus according to any one of the preceding claims, wherein a wavelength of the reference radiation is longer than a wavelength of the primary radiation.

6. An apparatus according to any one of the preceding claims, wherein the primary radiation is broadband radiation.

7. An apparatus according to any one of the preceding claims, wherein the primary radiation comprises radiation having a wavelength in the range 0.1-100 nm.

8. An apparatus according to any one of the preceding claims, wherein the second periodicity is an integer multiple of the first periodicity.

9. An apparatus according to any one of the preceding claims, wherein the diffractive optical element comprises a one-dimensional diffraction grating, wherein the first periodicity and the second periodicity are in a same direction.

10. An apparatus according to any one of claims 1 to 8, wherein the diffractive optical element comprises a two-dimensional diffraction grating, and further has a third periodicity and a fourth periodicity.

11. An apparatus according to claim 10, wherein the first periodicity and the second periodicity are in a first dimension, and the third periodicity and the fourth periodicity are in a second dimension; or
   wherein the first periodicity and the third periodicity are in a first dimension, and wherein the second periodicity and the fourth periodicity are in a second dimension

12. An apparatus according to claim 11, wherein the third periodicity is configured to diffract the primary radiation, and wherein the fourth periodicity is configured to diffract the reference radiation.

13. An apparatus according to claim 10, wherein the third and fourth periodicities are configured to diffract the reference radiation, and wherein the first periodicity is in a first dimension and the second, third, and fourth periodicities are in a second dimension.

14. An apparatus according to claim 10, wherein the third and fourth periodicities are configured to diffract the primary radiation, and wherein the second periodicity is in a first dimension, and the first, third, and fourth periodicities are in a second dimension.

15. A method for calibrating an apparatus, the method comprising:

illuminating a diffractive optical element with a primary radiation and a reference radiation, the diffractive optical element having a first periodicity configured to diffract the primary radiation, and a second periodicity configured to diffract the reference radiation; and
determining a wavelength related parameter of the diffracted primary radiation based on a wavelength related parameter of the diffracted reference radiation.

# Fig. 1

Fig. 2

Fig. 3

Fig. 4

Fig. 5

**Fig. 6**

**Fig. 7**

802

805

+1st

0th

-1st

806a    806

# Fig. 8

901

905

+2nd

+1st

0th

-1st

-2nd

906

(a)

902

905

+1st

0th

-1st

906

(b)

# Fig. 9

(a)

(b)

(c)

(d)

Fig. 10

Fig. 11

Fig. 12

1300

| S1302 |
| :---: |

| S1304 |
| :---: |

# Fig. 13

**EUROPEAN SEARCH REPORT**

Application Number

EP 24 21 6218

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 169 703 B1 (MOSSBERG THOMAS W [US] ET AL) 1 May 2012 (2012-05-01) | 1-7,9-15 | INV.<br>G03F7/00 |
| A | * column 3, line 54 - column 4, line 36; figures 2A, 2B, 3A, 3B *<br>* column 5, line 29 - column 6, line 55 * | 8 | |
| A | "ASSEMBLY FOR WAVELENGTH CALIBRATION", RESEARCH DISCLOSURE JOURNAL, QUESTEL ,<br>vol. 717, no. 14<br>28 November 2023 (2023-11-28),<br>XP007152044,<br>ISSN: 0374-4353<br>Retrieved from the Internet:<br>URL:https://www.researchdisclosure.com/database/RD717014<br>[retrieved on 2023-11-28]<br>* the whole document * | 1-15 | |
| A | "METHODS AND ASSEMBLIES FOR WAVELENGTH CALIBRATION", RESEARCH DISCLOSURE JOURNAL, QUESTEL ,<br>vol. 716, no. 82<br>16 November 2023 (2023-11-16),<br>XP007152007,<br>ISSN: 0374-4353<br>Retrieved from the Internet:<br>URL:https://www.researchdisclosure.com/database/RD716082<br>[retrieved on 2023-11-16]<br>* the whole document * | 1-15 | TECHNICAL FIELDS SEARCHED (IPC)<br><br>G03F |
| A | US 2020/098486 A1 (COENEN TEIS JOHAN [NL] ET AL) 26 March 2020 (2020-03-26)<br>* the whole document * | 1-15 | |

The present search report has been drawn up for all claims

| Place of search | Date of completion of the search | Examiner |
|---|---|---|
| Munich | 30 April 2025 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................

& : member of the same patent family, corresponding document

EPO FORM 1503 03.82 (P4C01)

## ANNEX TO THE EUROPEAN SEARCH REPORT
## ON EUROPEAN PATENT APPLICATION NO.

EP 24 21 6218

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2025

| Patent document cited in search report | | Publication date | Patent family member(s) | | Publication date |
|---|---|---|---|---|---|
| US 8169703 | B1 | 01-05-2012 | NONE | | |
| US 2020098486 | A1 | 26-03-2020 | EP | 3629086 A1 | 01-04-2020 |
| | | | US | 2020098486 A1 | 26-03-2020 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A1
- US 2011102753 A1
- US 20120044470 A
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B

- US 13033135 B
- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981 A1
- US 2016282282 A1

**Non-patent literature cited in the description**

- **LEMAILLET et al.** Intercomparison between optical and X-ray scatterometry measurements of FinFET structures. *Proc. of SPIE*, 2013, 8681